Europäisches Patentamt

European Patent Office

Office européen des brevets

(19)

(11) Veröffentlichungsnummer: **0 371 193**
**A1**

(12) **EUROPÄISCHE PATENTANMELDUNG**

(21) Anmeldenummer: **89112180.8**

(22) Anmeldetag: **04.07.89**

(51) Int. Cl.5: **H03K 7/06, H03K 9/06,
H03K 5/00**

(30) Priorität: **28.11.88 DE 3840073**

(43) Veröffentlichungstag der Anmeldung:
**06.06.90 Patentblatt 90/23**

(84) Benannte Vertragsstaaten:
**AT BE CH DE ES FR GB GR IT LI LU NL SE**

(71) Anmelder: **ROBERT BOSCH GMBH
Postfach 10 60 50
D-7000 Stuttgart 10(DE)**

(72) Erfinder: **Ciulin, Dan
Chemin des Daillettes 5
CH-1012 Pully(CH)**

(74) Vertreter: **Schmidt, Hans-Ekhardt, Dipl.-Ing.
Robert Bosch GmbH Geschäftsbereich
Mobile Kommunikation Patent- und
Lizenzabteilung Forckenbeckstrasse 9-13
D-1000 Berlin 33(DE)**

(54) Verfahren und Vorrichtung zur Wandlung eines Spannungssignals in ein Frequenzsignal und eines Frequenzsignals in ein Spannungssignal.

(57) Der Erfindung liegt die Aufgabe zugrunde, ein Verfahren zur Wandlung eines Spannungssignals in ein Frequenzsignal oder umgekehrt anzugeben, das die bei den Wandlern gemäß dem Stand der Technik auftretenden Unsymmetrien der Kennlinien vermeidet.

Die Lösung der Aufgabe besteht darin, daß das Spannungssignal integriert wird. Dabei wird abhängig von einem Amplituden-Grenzwert des integrierten Spannungssignals dessen Vorzeichen vor der Integration umgekehrt. Das integrierte Signal wird dann in ein cosinusförmiges Signal umgewandelt. Dadurch ergibt sich eine verhältnismäßig symmetrische Spannungs-Frequenzkennlinie, die auch dann erzielbar ist, wenn die maximale Frequenz der Eingangssignale größer als die Momentanfrequenz des Wandlers ist.

FIG. 1

## Verfahren und Vorrichtung zur Wandlung eines Spannungssignals in ein Frequenzsignal und eines Frequenzsignals in ein Spannungssignal

Die Erfindung betrifft ein Verfahren und eine Vorrichtung zur Wandlung eines Spannungssignals in ein Frequenzsignal und ein Verfahren und eine Vorrichtung zur Wandlung eines Frequenzsignals in ein Spannungssignal.

Spannungs-Frequenzwandler nach dem Stand der Technik weisen eine nicht-symmetrische lineare Spannungs-Frequenzkennlinie auf. Um eine pseudosymmetrische Kennlinie zu erzielen, muß ein Spannungsoffset und ein Frequenzoffset eingeführt werden und das Eingangssignal an diesen Spannungsoffset geklammert werden. Ein Frequenzoffset kann durch einen Frequenzwandler vorgegeben werden. Trotz dieser Ausführung ist es zur Zeit nur möglich, Spannungs-Frequenzwandler herzustellen, deren Eingangsfrequenz um drei- bis fünfmal geringer sein muß als die momentane Ausgangsfrequenz des Konverters. Frequenz-Spannungswandler nach dem Stand der Technik weisen ebenfalls eine nichtsymmetrische lineare Frequenz-Spannungskennlinie auf. Außerdem wird bei bekannten Frequenz-Spannungswandler die momentane Frequenz in eine Spannung umgewandelt, sondern der Mittelwert der momentanen Frequenz.

Der Erfindung liegt daher die Aufgabe zugrunde, einen Spannungs-Frequenzwandler bzw. einen Frequenz-Spannungswandler zu schaffen, die eine symmetrische Spannungs-Frequenzkennlinie bzw. Frequenz-Spannungskennlinie aufweisen, wobei der Spannungs-Frequenzwandler auch für Eingangssignale anwendbar sein soll, deren maximale Frequenz über der momentanen Ausgangsfrequenz des Konverters liegen soll und wobei der Frequenz-Spannungswandler die Wandlung auch für momentane Frequenzen durchführen soll.

Diese Aufgabe wird bei einem Verfahren und einer Vorrichtung zur Wandlung eines Spannungssignals in eine Frequenzsignal durch die kennzeichnenden Merkmale des Anspruchs 1 bzw. 7 und bei einem Verfahren und einer Vorrichtung zur Wandlung eines Frequenzsignals in ein Spannungssignal gemäß den kennzeichnenden Merkmalen des Anspruchs 14 bzw. 15 gelöst. Die mit der Erfindung erzielbaren Vorteile bestehen insbesondere darin, daß durch Integration des Eingangssignals in einem Integrierer bei vorangehender Vorzeichenumkehr abhängig von einem Grenzwert für das Ausgangssignal des Integrierers mittels eines Multiplizierers und durch Umwandlung des resultierenden Signals in ein kosinusförmiges Ausgangssignal ein möglich symmetrischer Spannungs-Frequenzwandler zur Verfügung gestellt wird. Als weiterer Vorteil ist anzusehen, daß mit dem erfindungsgemäßen Verfahren und der Vorrichtung eine Spannungs-Frequenzwandlung selbst für Eingangssignale vorgenommen werden kann, deren maximale Frequenz größer als die Momentanfrequenz des Wandlers ist.

Um bei einer derartigen Vorrichtung zur Wandlung eines Spannungssignals in ein Frequenzsignal den Frequenzbereich zu vergrößern, werden nach einer weiteren Ausbildung der Erfindung das kosinusförmige Ausgangssignal und ein entsprechendes sinusförmiges Ausgangssignal in einem Multiplizierer jeweils mit sich selber multipliziert und das resultierende sinusförmige Signal in einem Differenzbildner von dem resultierenden kosinusförmigen Signal subtrahiert. Somit wird der Frequenzbereich verdoppelt, wobei eine weitere Vergrößerung durch Hintereinanderschalten mehrerer derartiger Stufen erzielt werden kann.

In einer vorteilhaften Weiterbildung kann eine Vorrichtung zur Wandlung eines Frequenzsignals in ein Spannungssignal mit symmetrischer Spannungs-Frequenzkennlinie durch Vorsehen der symmetrischen Vorrichtung zur Wandlung eines Spannungssignals in ein Frequenzsignal in der Rückschleife eines phasenempfindlichen Regelkreises erreicht werden.

Ausführungsbeispiele der Erfindung sind in der Zeichnung dargestellt und werden in der nachfolgenden Beschreibung näher erläutert. Es zeigen:

Fig. 1 eine schaltungsgemäße Ausgestaltung in Blockdarstellung eines Ausführungsbeispiels der erfindungsgemäßen Vorrichtung zur Wandlung eines Spannungssignals in ein Frequenzsignal,

Fig. 2 die Darstellung von Spannungssignalen an unterschiedlichen Stellen der Vorrichtung nach Fig. 1,

Fig. 3 die Frequenz-Spannungskennlinie der Vorrichtung nach Fig. 1,

Fig. 4 die schaltungsgemäße Ausgestaltung eines Schaltkreises zur Vergrößerung des Frequenzbereiches der erfindungsgemäßen Vorrichtung nach Fig. 1,

Fig. 5 die schaltungsgemäße Ausgestaltung eines Ausführungsbeispiels der Vorrichtung zur Wandlung eines Frequenzsignals in ein Spannungssignal, und

Fig. 6 eine schaltungsgemäße Ausgestaltung eines weiteren Ausführungsbeispiels der Vorrichtung zur Wandlung eines Spannungssignals in ein Frequenzsignal.

Das Ausgangssignal $U_f$ eines symmetrischen Spannungs-Frequenzwandlers kann durch die folgende Gleichung dargestellt werden:

$$U_f \text{ "cosine"} = U_{fc} = U_o \cos\left[\int \beta U_i(t)\, dt + \phi\right] = U_o \cos(\alpha)$$

wobei $U_o$ die Ausgangsamplitude, $U_i$ (t) das Eingangssignal, $\phi$ eine durch den Konverter vorgegebene konstante Phase, $\beta$ ein Skalenfaktor $(2 \pi t_g)$ und t die Zeit sind.

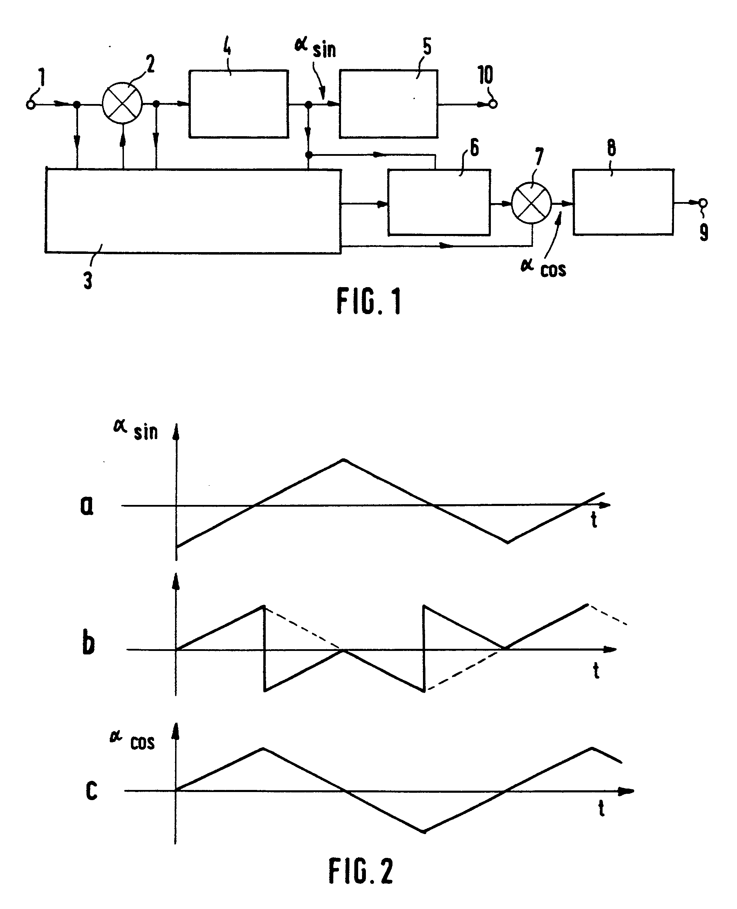

Ein Spannungs-Frequenzwandler mit einem derartigen Ausgangssignal ist in Fig. 1 dargestellt. Danach ist der Eingang 1 mit einem Multiplizierer 2 und einem logischen Schaltkreis 3 verbunden. Der logische Schaltkreis besteht vorzugsweise aus mehreren Komparatoren und einem digitalen Netzwerk, bestehend aus UND-Gattern, ODER-Gattern, einem X ODER-Gatter und einem Flip-Flop. Ein Ausgang des logischen Schaltkreises 3 ist an einen weiteren Eingang des Multiplizierers 2 angeschlossen. Der Ausgang des Multiplizierers steht mit dem Eingang eines Integrierers 4 in Verbindung, dessen Ausgang an einen Sinuswandler 5 den logischen Schaltkreis 3 und einen Addierer 6 angeschlossen ist. An einen weiteren Eingang des Addierers 6 liegt ein Ausgang des logischen Schaltkreises 3. Der Ausgang des Addierers 6 ist mit einem zweiten Multiplizierer 7 verbunden, an dessen zweiten Eingang ein weiterer Ausgang des logischen Schaltkreises liegt. An den Ausgang des zweiten Multiplizierers 7 ist ein weiterer Sinuswandler 8 angeschlossen.

Das am Eingang 1 anliegende Eingangssignal $U_i$(t) kann eine beliebige Wellenform aufweisen.Zum klaren Verständnis wird im folgenden unter Bezugnahme auf Fig. 2 die Funktion anhand eines Gleichspannungseingangssignals erläutert. Das Eingangssignal $U_i$(t)wird im Integrator 4 integriert, wobei sich ein linear ansteigendes Signal ergibt. Der Integrator ist so ausgelegt, daß seine Ausgangsspannung auf eine vorgegebene Amplitude begrenzt wird. Wenn diese Ausgangsspannung infolge des Spannungsverlaufs des Eingangssignals diese erreicht, wird das Vorzeichen des Signals am Eingang des Integrators 4 umgeschaltet.

Dies erfolgt über den ersten Multiplizierer 2, der das Eingangssignal mit + oder - 1 multipliziert,und zwar abhängig von einem vom logischen Schaltkreis 3 gelieferten Steuersignal.

Wenn das Eingangssignal $U_i$ (t) ein Gleichspannungssignal ist, wird am Ausgang des Integrators 4 ein dreieckförmiges Signal nach Fig. 2a geliefert, wobei jeweils der erste Multiplizierer 2 mit + oder - multipliziert, und die Vorzeichenumkehr jeweils am Minimum bzw. Maximum des dreieckförmigen Signals nach Fig. 2 erfolgt. Das dreieckförmige Signal gelangt auf den zweiten Sinuswandler 5, in dem es in ein Sinussignal umgewandelt wird, wobei das Signal zuerst in einem Verstärker verschoben wird und die positive Spitze des dreieckförmigen Signals in einer nichtlinearen Differentialstufe zu einer Sinusform gerundet wird. Das Signal gelangt dann weiter über eine Pufferstufe und einen Spannungsteiler auf einen weiteren Verstärker zur Verschiebung des Signals und gelangt auf eine weitere nichtlineare Differentialstufe, in der die negative Spitze des dreieckförmigen Signals in eine Sinusform gerundet wird. Über eine weitere Pufferstufe und einen Spannungsteiler gelangt das so geformte Signal zu einem Ausgangsverstärker, der ein echtes Sinussignal

$$U_{f\,sin} = U_o. \sin [\int \beta\, U_i(t)\, dt + \phi]$$

liefert. Die beschriebene Anordnung des Sinuswandlers 5 wird nur beispielhaft angegeben, selbstverständlich können auch anders ausgebildete Sinuswandler verwendet werden. Um ein echtes Kosinussignal am Ausgang des ersten Sinuswandlers 8 zu erzielen, muß das am Ausgang des Integrators 4 liegende dreieckförmige Signal $\alpha$ sin modifiziert werden, um ein neues dreieckförmiges Signal $\alpha$ cos zu bilden, das nach Bearbeitung durch den ersten Sinuswandler 8 das durch die obige Gleichung angegebene echte Kosinussignal liefert.Zur Modifizierung des dreieckförmigen Signals $\alpha$ sin dienen der Addierer 6 und der Multiplizierer 7. Gemäß Fig. 2 wird dem dreieckförmigen Signal $\alpha$sin ein Offsetwert in dem Addierer 6 hinzugefügt, wobei die Addition vom Vorzeichen des Signals $\alpha$ sin abhängt, d.h. der Offsetwert wird immer dann in seinem Vorzeichen geändert, wenn das Signal $\alpha$ sin durch Null geht. Es entsteht somit das Signal nach Fig. 2b in den durchgezogenen Linien, das am Ausgang des Addierers 6 anliegt. In dem durch die gestrichelten Linien angedeuteten Bereich wird durch Multiplikation im Multiplizierer 7 um ± 1 die Steigung, so daß sich am Ausgang des Multiplizierers 7 das Signal $\alpha$cos nach Fig. 2c ergibt. Die Ansteuerung des Addierers 6 und des Multiplizierers 7 erfolgt abhängig von vom logischen Schaltkreis 3 gelieferten Steuersignalen, die wiederum abhängig vom Eingangssignal und vom Ausgangssignal des Integrierers 4 erzeugt werden. Der erste Sinuswandler 8 transformiert das dreieckförmige Signal $\alpha$ cos am Ausgang des Multiplizierers 7 in ein kosinusförmiges Signal entsprechend der oben angegebenen Formel.

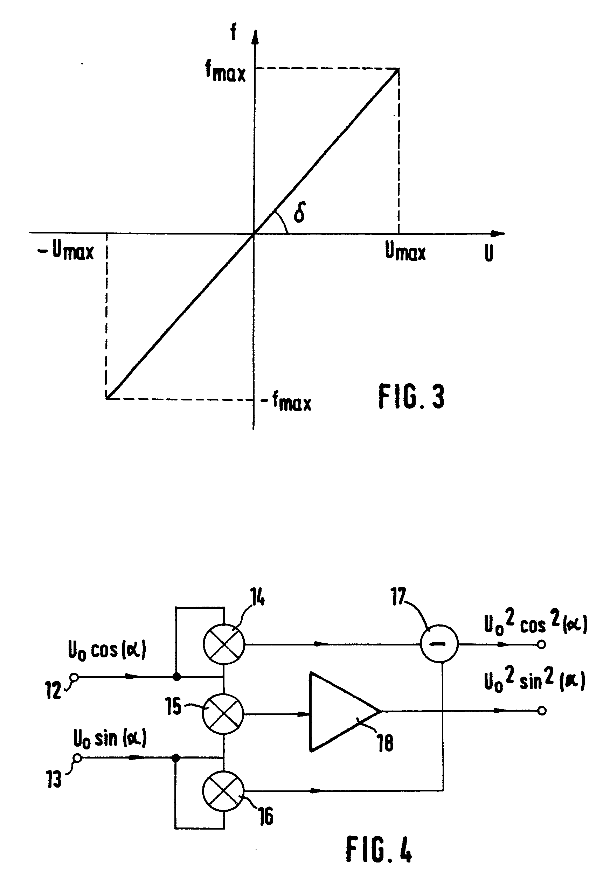

Der in Fig. 1 dargestellte Spannungs-Frequenzwandler weist eine wirkliche symmetrische Frequenz-Spannungskennlinie nach Fig. 4 auf. Entsprechend dieser Darstellung ergeben sich für negative Eingangsspannungen negative Frequenzen. Wie schon oben dargestellt, kann das Ausgangssignal durch $U_f \cos = U_o{}^{\bullet} \cos [\int \beta\, U_i\,(t)\, dt + \phi] = U_o. \cos (\omega_i t + \phi)$ dargestellt werden, wobei $\omega_i/2 \pi$ als momentane Frequenz angesehen werden kann. Bei Berücksichtigung einer negativen momentanen Frequenz ergibt sich:

$$U_f = U_o\cos (- \omega_i t + \phi) = U_o \cos (\omega_i t - \phi).$$

Das bedeutet, daß eine negative Frequenz einer positiven Frequenz mit negativer Phase entspricht. Der Spannungs-Frequenzwandler nach Fig. 1 arbeitet entsprechend, so daß auch negative Frequenzen realisiert werden können.

Der Spannungs-Frequenzwandler gemäß Fig. 1 ist selbst für Eingangssignale zu verwenden, deren maximale Frequenz größer ist als die momentane Frequenz des Wandlers. Die Stabilität hängt im wesentlichen vom Integrator 4 ab.

In Fig. 4 ist eine Schaltung zur Vergrößerung des Frequenzbereiches eines Spannungs-Frequenzwandlers nach Fig. 1 dargestellt. Diese Schaltung ist mit ihren Eingangsklemmen 12, 13 an die Ausgänge 9, 10 des Spannungs-Frequenzwandlers anzuschließen, wobei die Klemme 12, an der das Eingangssignal $U_o \cos(\alpha)$ anliegt, mit den zwei Eingängen eines dritten Multiplizierers 14 und dem einen Eingang eines vierten Multiplizierers 15 verbunden ist und die Eingangsklemme 13, an der das Signal $U_o \sin(\alpha)$ anliegt, mit den zwei Eingängen eines fünften Multiplizierers 16 und dem anderen Eingang des vierten Multiplizierers 15 verbunden ist.

Die Ausgänge des dritten und des fünften Multiplizierers 14, 16 liegen an den Eingängen eines Differenzbildners 17, während der Ausgang des vierten Multiplizierers 15 an einen Verstärker mit dem Verstärkungsfaktor 2 angeschlossen ist.

Die Funktion der Schaltung gemäß Fig. 4 ist wie folgt: das Eingangssignal an der Eingangsklemme 12 wird in dem dritten Multiplizierer 14 mit sich selber multipliziert, d.h. am Ausgang des dritten Multiplizierers 14 und somit am Eingang des Differenzbildners 17 liegt das Signal $U_o^2 \cos 2(\alpha)$ an. Entsprechend wird in dem fünften Multiplizierer 16 ein Signal $U_o^2 \sin 2(\alpha)$ erzeugt. In dem Differenzbildner 17 wird die Differenz der beiden Signale gemäß

$$U_o^2 \cos^2(\alpha) - U_o^2 \sin^2(\alpha) = U_o^2 \cos(2\alpha)$$

gebildet, wobei aus dieser Gleichung zu erkennen ist, daß der Frequenzbereich des Konverters zu verdoppeln ist.

In dem vierten Multiplizierer 15 werden die beiden Eingangssignale an den Klemmen 12, 13 miteinander multipliziert und im Verstärker 18 um den Faktor 2 verstärkt, so daß sich folgende Gleichung ergibt:

$$2U_o^2 \sin(\alpha) \cos(\alpha) = U_o^2 \sin(2\alpha).$$

Somit wird am Ausgang der Schaltung nach Fig. 4 auch ein Sinussignal mit verdoppeltem Frequenzbereich erhalten.

Mit der Schaltung nach Fig. 4 ist es möglich, den Frequenzbereich eines Spannungs-Frequenzwandlers um den Faktor 2 zu erweitern. Um eine Erweiterung um den Faktor $2^N$ zu erzielen, können mehrere Stufen nach Fig. 4 hintereinandergeschaltet werden, wobei allerdings die Ausgangsspannung nach jeder Stufe auf einen geeigneten Wert gedämpft werden muß, damit nicht der Amplitudenbereich überschritten wird.

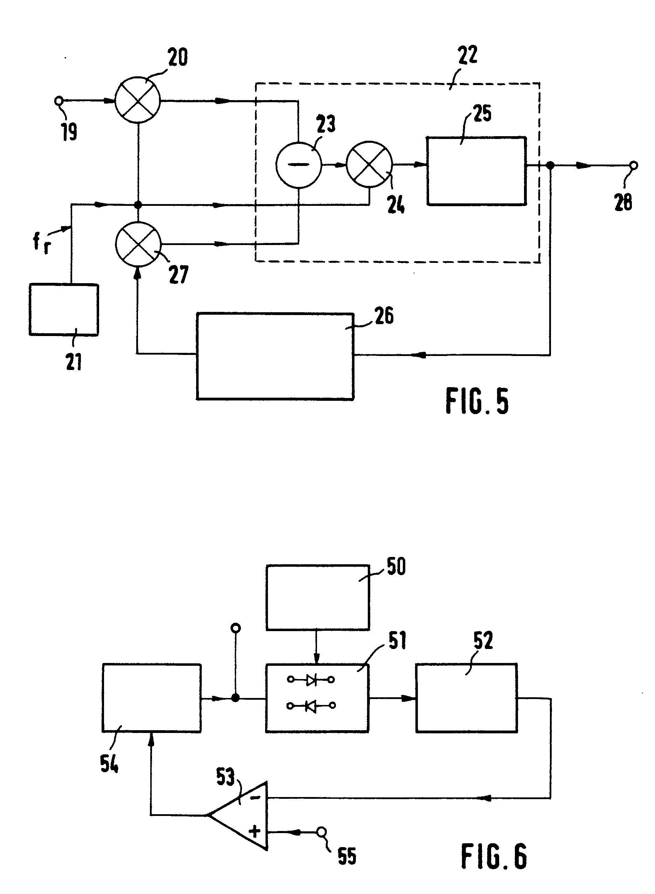

Mit Hilfe des Spannungs-Frequenzwandlers nach Fig. 1 läßt sich nach Fig. 5 ein Frequenz-Spannungswandler herstellen, der eine symmetrische Frequenz-Spannungskennlinie aufweist, die der Kennlinie nach Fig. 3 entspricht, wobei allerdings die Y-Achse die Spannung und die X-Achse die Frequenz darstellt. Der Frequenz-Spannungswandler nach Fig. 5 weist einen ersten Mischer 20 auf, dessen Eingänge einerseits mit der Eingangsklemme 19 und andererseits mit einem Referenzoszillator 21, der eine Referenzfrequenz $f_r$ liefert, verbunden ist. Der Ausgang des Mischers liegt an einem Synchrondetektor 22 an, der die Reihenschaltung aus einem Differenzbildner 23, einem zweiten Mischer 24 und einem Tiefpaß 25 aufweist. Der zweite Mischer 24 ist ebenfalls mit dem Referenzoszillator 21 verbunden. In einer Rückschleife ist ein Spannungs-Frequenzwandler nach Fig. 1 an den Ausgang des Synchrondetektors 22 geschaltet, wobei der Ausgang des Spannungs-Frequenzwandlers 26 mit einem dritten Mischer 27 verbunden ist, an dessen anderem Ende der Referenzoszillator 21 liegt. Der Ausgang des dritten Mischers 27 steht mit dem zweiten Eingang des Differenzbildners 23 in Verbindung.

Die Funktionsweise des in Fig. 5 dargestellten Frequenz-Spannungswandlers ist wie folgt:

Das an der Klemme 19 anliegende Eingangssignal wird in dem ersten Mischer 20 mit der höheren Referenzfrequenz $f_r$, die in etwa mindestens fünf- bis zehnmal größer ist als die Maximalfrequenz des Eingangssignals, multipliziert, d.h. es wird nach höheren Frequenzen hin verschoben. Dies ist notwendig, um ein einwandfreies Arbeiten des Synchrondetektors 22 zu gewährleisten und die Zeitkonstante der als phasenempfindlicher Regelkreis ausgebildeten Schaltung klein zu halten. Dadurch hat der Tiefpaß 25 eine Zeitkonstante von drei bis fünf Perioden des Referenzoszillators 21 und nicht des Eingangssignals. Wenn die Referenzfrequenz $f_r$ groß genug gewählt wird, so kann das Eingangssignal in so viele Zeitintervalle eingeteilt werden, wie in Betracht gezogen werden können, so daß die Steuerung in "Phase" realisiert werden kann. Über den Differenzbildner 23 wird die "Phase" des Eingangssignals mit der "Phase" des mittels des Spannungs-Frequenzwandlers 26 rekonstruierten Signals verglichen und die resultierende "Phase" wird von dem analogen "Phasendetektor", der vom zweiten Mischer 24 und vom Tiefpaß 25 gebildet wird, in eine Spannung umgesetzt. Dieser "Phasendetektor" vergleicht die Phase des Referenzoszillators 21 mit der Phase des Ausgangssignals des als Operationsverstärkers ausgebildeten Differenzbildners 28.

Diese Anordnung rekonstruiert jedes Signal, wenn ihre maximale Momentanfrequenz mindestens geringer als $f_r$ (5 bis 10), um die Bedingung der "Phase" zu erfüllen, und wenn ihre Amplitude nicht die maximale Amplitude am Spannungs-Frequenzwandler 26 übersteigt.

Wegen der Symmetrie liegt am Ausgang des Spannungs-Frequenzwandlers 26 das gleiche Signal an wie am Eingang 19, wenn das Eingangssignal nicht den Bereich der Systemparameter übersteigt. Für diesen Fall kann die Schaltung nach Fig. 5 als wirklich symmetrischer Frequenz-Spannungswandler betrachtet werden.

Aufgrund der oben beschriebenen Eigenschaften kann der symmetrische Spannungs-Frequenzwandler gemäß der Erfindung als wirklicher Phasen/Frequenzmodulator und der symmetrische Frequenz-Spannungswandler als wirklicher Phasen-Frequenzdemodulator verwendet werden.

In Fig. 6 ist ein weiteres Ausführungsbeispiel eines Spannungs-Frequenz-Wandlers auf der Basis eines PLL-Kreises aufgebaut. Dabei ist ein Referenzoszillator 50 mit einem Phasendiskriminator 51 verbunden, der in dem aus dem Phasendiskriminator 51, einem Tiefpaß 52, einem Verstärker 53 und einem spannungsgesteuerten Oszillator VCO 54 bestehenden PLL-Kreis liegt. Das Eingangssignal wird an den zweiten Eingang 55 des Operationsverstärkers 53 angelegt, während das Ausgangssignal am Ausgang des VCO 54 abgenommen werden kann.

Wenn keine Spannung am Eingang 55 anliegt, wird der VCO auf die Phase des Referenzoszillators synchronisiert. Bei kleinen Eingangssignaländerungen und kleiner Amplitude ändert sich die Phase des VCO 54 und es wird ein Ausgangssignal erzeugt, das etwa gleich dem Eingangssignal ist.

Bei einem großen Sprung der Eingangsspannung wird der VCO 54 auch die Frequenz ändern, wobei allerdings der PLL-Kreis nicht mehr die Phase verfolgen kann, wenn diese Phase außerhalb des Bereichs liegt (Frequenzänderung) oder sich zu schnell ändert (momentane Frequenzänderung), wobei auch die Zeitkonstante des Tiefpasses eine Rolle spielt.

Für kleine Änderungen kann der Spannungs-Frequenz-Wandler als wirklich symmetrischer Spannungs-Phasen-Wandler angesehen werden.

## Ansprüche

1. Verfahren zur Wandlung eines Spannungssignals in ein Frequenzsignal
**dadurch gekennzeichnet,**
daß das Spannungssignal integriert wird, wobei abhängig von einem Grenzwert für die Amplitude des integrierten Spannungssignals das Vorzeichen des Spannungssignals vor der Integration umgekehrt wird und daß das integrierte Signal in ein kosinusförmiges Signal umgewandelt wird.

2. Verfahren nach Anspruch 1, dadurch gekennzeichnet, daß vor Umwandlung in das kosinusförmige Signal das integrierte Signal um 90° in der Phase geändert wird.

3. Verfahren nach Anspruch 2, dadurch gekennzeichnet, daß die Phasenänderung durch Addition bzw. Subtraktion eines Versatzwertes mit bzw. vom integrierten Signal und durch Umkehr des Vorzeichens in Teilbereichen des Signals erfolgt.

4. Verfahren nach einem der Ansprüche 1 bis 3, dadurch gekennzeichnet, daß zusätzlich das integrierte Signal in ein sinusförmige Signal umgewandelt wird.

5. Verfahren nach einem der Ansprüche 1 bis 4, dadurch gekennzeichnet, daß zur Erweiterung des Frequenzbereiches das sinusförmige und das kosinusförmige Signal jeweils mit sich selber multipliziert werden und das resultieren de sinusförmige Signal vom resultierenden kosinusförmigen Signal abgezogen wird.

6. Verfahren nach Anspruch 5, dadurch gekennzeichnet, daß das sinusförmige Signal mit dem kosinusförmigen Signal multipliziert wird und das resultierende Signal verdoppelt wird.

7. Vorrichtung zur Wandlung eines Spannungssignals in ein Frequenzsignal unter Anwendung des Verfahrens nach Anspruch 1,
**dadurch gekennzeichnet,**
daß der Eingang (1) über einen ersten, die Vorzeichenumkehr durchführenden Multiplizierer (2) mit einem Integrator (4) verbunden ist, an dessen Ausgang ein Addierer (6) liegt, der über einen zweiten Multiplizierer (7) an einen ersten Sinuswandler (8) geschaltet ist, wobei die Multiplizierer (2,7) und der Addierer (6) mit einem logischen Schaltkreis (3) verbunden sind, der die Additions- und Multiplikationsvorgänge steuert.

8. Vorrichtung nach Anspruch 7, dadurch gekennzeichnet, daß der Integrator (4) direkt mit einem zweiten Sinuswandler (5) verbunden ist.

9. Vorrichtung nach Anspruch 7 oder 8, dadurch gekennzeichnet, daß die Sinuswandler (5,8) als nichtlineare Sinuswandler ausgebildet sind.

10. Vorrichtung nach einem der Ansprüche 7 bis 9, dadurch gekennzeichnet, daß der Grenzwert für die Vorzeichenumkehr im ersten Multiplizierer (2) durch die Begrenzung der Ausgangsspannung des Integrierers (4) auf eine vorgegebene Amplitude bestimmt ist.

11. Vorrichtung nach einem der Ansprüche 7 bis 10, dadurch gekennzeichnet, daß zur Erweiterung des Frequenzbereichs der erste Sinuswandler (8) mit den beiden Eingängen eines dritten Multiplizierers (14) und dem einen Eingang eines vierten Multiplizierers (15) verbunden ist und der zweite Sinuswandler (5) an die zwei Eingänge eines fünften Multiplizierers (16) und den anderen Eingang des vierten Multiplizierers (15) angeschlossen sind und daß der Ausgang des dritten Multiplizierers (14) und der des fünften Multiplizierers (16) mit einem Differenzbildner (17) und der Ausgang des vierten Multiplizierers (15) zur Verstärkung um den Faktor 2 mit einem Verstärker (18) in Verbindung stehen.

12. Vorrichtung nach Anspruch 11, dadurch gekennzeichnet, daß mehrere hintereinandergeschaltete Stufen, bestehend aus den drei Multiplizierern (14,15,16), dem Differenzbildner (17) und dem Verstärker (18) vorgesehen sind.

13. Vorrichtung nach Anspruch 12, dadurch gekennzeichnet, daß nach jeder Stufe ein Dämpfungsglied zur Dämpfung der Ausgangsspannung vorgesehen ist.

14. Verfahren zur Wandlung eines Frequenzsignals in ein Spannungssignal unter Anwendung der Ansprüche 1 bis 6, dadurch gekennzeichnet, daß das ein Frequenzsignal bildende Eingangssignal mittels einer Referenzfrequenz nach höheren Frequenzen verschoben wird und seine Phase mit der Phase des über einen Spannungs-Frequenzwandler rückgeführten, in die höheren Frequenzen verschobenen Ausgangssignals verglichen wird und daß die Phase des Vergleichssignals mit der Phase der Referenzfrequenz verglichen wird.

15. Vorrichtung zur Wandlung eines Frequenzsignals in ein Spannungssignal unter Anwendung des Verfahrens nach Anspruch 14 und der Vorrichtung nach einem der Ansprüche 7 bis 12, dadurch gekennzeichnet, daß ein erster Mischer (20) vorgesehen ist, der einerseits das Eingangssignal erhält und andererseits mit einem Referenzoszillator (21) verbunden ist, daß ein dritter Mischer (27) vorgesehen ist, der einerseits mit dem Referenzoszillator (21) und andererseits mit einem in eine Rückkopplungsschleife geschalteten Spannungs-Frequenzwandler verbunden ist, daß die Ausgänge des ersten und des dritten Mischers (20,27) mit einem Differenzbildner (23) verbunden sind, dessen Ausgang ebenso wie der des Referenzoszillators (21) an einen Phasendetektor (24,25) angeschlossen ist, wobei der Ausgang des Phasendetektors an den Eingang des Spannungs-Frequenzwandlers (26) rückgeführt ist.

16. Vorrichtung nach Anspruch 15, dadurch gekennzeichnet, daß der Phasendetektor (24,25) einen mit dem Differenzbildner (23) und dem Referenzoszillator (21) verbundenen zweiten Mischer (24) und einen an ihn anschließenden Tiefpaß (25) aufweist.

17. Vorrichtung nach Anspruch 15 oder 16, dadurch gekennzeichnet, daß die Referenzfrequenz des Referenzsignals mindestens fünf- bis zehnmal größer ist als die größte Momentanfrequenz des Eingangssignals.

18. Vorrichtung zur Wandlung eines Spannungssignals in ein Frequenzsignal, dadurch gekennzeichnet, daß ein PLL-Kreis bestehend aus Phasendiskriminator (51), Tiefpaß (52), Operationsverstärker (53) und spannungsgesteuertem Oszillator (54) vorgesehen ist, wobei am Phasendiskriminator (51) eine Referenzspannung anliegt und daß das Eingangssignal der Vorrichtung an einem weiteren Eingang des Operationsverstärkers (53) angelegt wird.

FIG. 1

FIG. 2

EP 0 371 193 A1

**FIG. 3**

**FIG. 4**

EP 0 371 193 A1

**FIG.5**

**FIG.6**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | RADIO FERNSEHEN ELEKTRONIK, Band 25, Heft 6, 1976, Seiten 193-197; G. VOLKHOLZ: "Wobbelbarer Dreieck-, Rechteck- und Sinusgenerator" * Seite 193, Spalte 1, Zeile 27 - Spalte 3, Zeile 7; Seite 194, Spalte 1, Zeile 4 - Spalte 2, Zeile 3; Figuren 1-3,6 * | 1 | H 03 K 7/06<br>H 03 K 9/06<br>H 03 K 5/00 |
| A | IDEM | 7,10 | |
| Y | F.M. GARDNER: "Phaselock Techniques", 1979, Seiten 8-15,164-177, Wiley, US * Seite 11, Zeilen 16-18; Seite 165, Zeile 14 - Seite 166, Zeile 6; Seite 166, Zeilen 17-18; Seite 175, Zeilen 1-9; Figuren 9.1,9.2 * | 18 | |
| A | IDEM | 14-17 | |
| X | IEE PROCEEDINGS SECTIONS A a I, Band 130, Nr. 7, December 1983, Seiten 489-494; J.R. FORREST et al.: "Fast acquisition phase-locked loops for frequency agile pulsed radar systems" * Seite 490, Spalte 2, Zeilen 4-6; Figuren 1,6 * | 18 | **RECHERCHIERTE SACHGEBIETE (Int. Cl.5)**<br><br>H 03 K<br>G 05 D<br>H 03 L |
| A | IDEM | 1 | |
| A | US-A-3 760 248 (F.J. NOLA) * Spalte 1, Zeilen 20-38; Figuren 1-3 * ---  -/- | 1,2,18 | |

Der vorliegende Recherchenbericht wurde für alle Patentansprüche erstellt

| Recherchenort | Abschlußdatum der Recherche | Prüfer |
|---|---|---|
| DEN HAAG | 23-01-1990 | BUTLER N.A. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
.......................................................................................................
& : Mitglied der gleichen Patentfamilie, übereinstimmendes
    Dokument

EPO FORM 1503 03.82 (P0403)

## Europäisches Patentamt

## EUROPÄISCHER RECHERCHENBERICHT

Nummer der Anmeldung

EP 89 11 2180

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | INSTRUMENTS AND CONTROL SYSTEMS, Band 45, Nr.6, Juni 1972, Seiten 83-85; J. PEPPER: "Analog Multiplier Applications" <br> * Seite 84, Zeilen 7-30; Seite 84, Zeile 52 - Seite 85, Zeile 4; Figuren 4-6 * <br> ----- | 1,5-7, 11,12, 16,18 | |
| | | | **RECHERCHIERTE SACHGEBIETE (Int. Cl.5)** |

Der vorliegende Recherchenbericht wurde für alle Patentansprüche erstellt

| Recherchenort | Abschlußdatum der Recherche | Prüfer |
|---|---|---|
| DEN HAAG | 23-01-1990 | BUTLER N.A. |

EPO FORM 1503 03.82 (P0403)